# FASCICULE DE BREVET EUROPEEN

(11) **EP 0 367 348 B1**
(45) Date de publication et mention de la délivrance du brevet: **28.12.1994**
(21) Numéro de dépôt: 89202738.4
(22) Date de dépôt: 30.10.1989
(51) Int. Cl.: H03J 1/06, H03H 1/00

(54) **Composant passif réglable**
Einstellbare passive Komponente
Adjustable passive component

(30) Priorité: 04.11.1988 FR 8814426
(43) Date de publication de la demande: 09.05.1990
(73) Titulaire: PHILIPS ELECTRONIQUE GRAND PUBLIC, 92150 Suresnes (FR); Philips Electronics N.V., 5621 BA Eindhoven (NL)
(72) Inventeur: Chanteau, Pierre Société Civile S.P.I.D., F-75008 Paris (FR); Da Silva, Eric Société Civile S.P.I.D., F-75008 Paris (FR)
(74) Mandataire: Charpail, François

(56) Documents cités:
- CH-A- 315 733
- DE-A- 2 742 905
- FR-A- 2 317 811

## Description

La présente invention a pour objet un composant passif réglable, pour signaux d'au moins 300 MHz, composé d'au moins deux éléments connectés entre eux à savoir un élément selfique et un élément d'impédance de valeur réglable lequel élément comporte à une extrémité un embout accessible pour son réglage.

Un tel composant constitue un circuit électrique élémentaire à utiliser dans l'industrie électrique; lorsque l'élément d'impédance variable est principalement capacitif on obtient un circuit oscillant ou un circuit bouchon selon le schéma de montage.

Dans les composants connus, l'embout accessible pour le réglage est généralement une tête de vis et l'outil de réglage est un tournevis généralement métallique, c'est-à-dire conducteur. Ainsi, même en prenant des précautions d'isolation, la présence momentanée de la masse métallique du tournevis perturbe le fonctionnement du composant ce qui contrarie le réglage.

La présente invention a pour but de supprimer cet inconvénient.

Un composant conforme à la présente invention est particulièrement remarquable en ce que le dit élément selfique est constitué au moyen d'un conducteur creux d'une extrémité à l'autre et dont une extrémité est connectée au dit élément d'impédance réglable, et en ce que le dit embout de réglage est situé en vis à vis du dit creux selon un agencement tel que d'une part l'embout est accessible à travers le dit creux pour son réglage, d'autre part l'introduction, même momentanée, d'un outil de réglage dans le dit creux ne perturbe pas le fonctionnement du composant passif réglable.

Il est connu que les courants électriques de haute fréquence se propagent essentiellement en surface; c'est l'effet de peau bien connu; dans le cas présent, il n'y a pratiquement pas de courant HF sur la surface interne de l'élément conducteur creux et dès lors la seule présence, même momentanée, d'une masse métallique telle qu'un tournevis ne modifie pas le fonctionnement du composant passif réglable.

De préférence l'élément selfique conducteur creux a une forme tubulaire cylindrique ou légèrement conique, et le diamètre intérieur du tube est dimensionné pour pouvoir guider le tournevis de réglage.

Cette disposition permet bien sûr un réglage manuel, mais aussi et surtout un réglage automatique car il suffit que le tube soit légèrement conique pour que le tournevis "trouve" facilement la vis de réglage; la légère conicité est aisément obtenue par exemple dans le cas où la self est réalisée par moulage d'un matériau conducteur ou non, mais dans ce cas revêtu au moins extérieurement d'une couche conductrice.

La présente invention sera mieux comprise à l'aide des exemples non limitatifs de réalisation illustrés par les dessins suivants :

La figure 1 représente, pour mémoire, le schéma d'un circuit oscillant.

La figure 2 représente le montage pratique d'un circuit oscillant connu.

La figure 3 représente le montage pratique d'un circuit oscillant selon l'invention.

La figure 4 représente le schéma d'un composant conforme à l'invention.

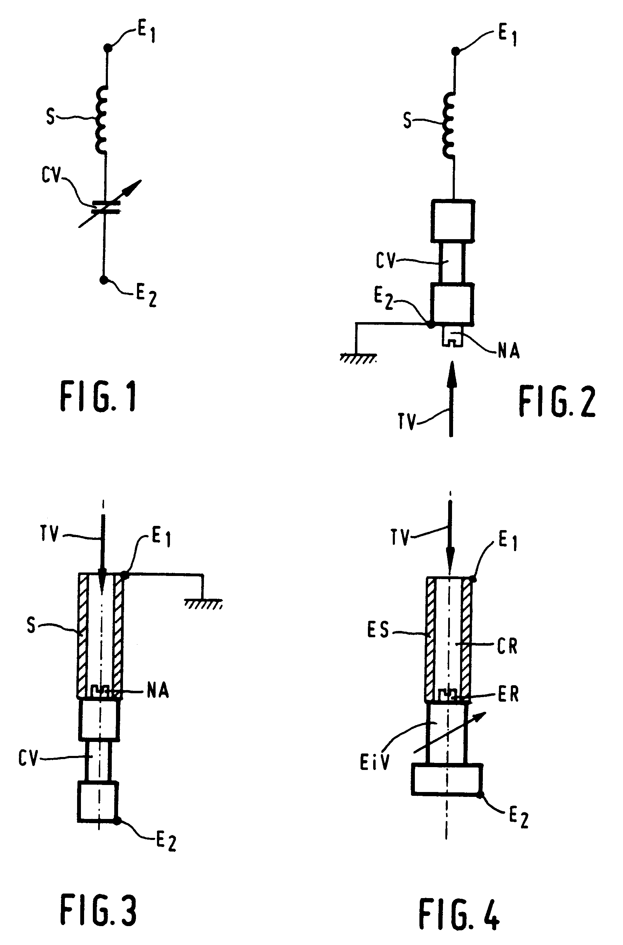

Sur la figure 1 le schéma comporte un élément selfique S et un condensateur variable CV montés en série entre deux bornes E1, E2; sur le plan des principes, rien n'oblige les bornes E1 et E2 à être connectées à une valeur de potentiel plutôt qu'à une autre.

Toutefois, dans la pratique, avec un condensateur variable CV comportant un noyau ajustable NA, tel que représenté dans la figure 2, le tournevis TV, présent momentanément lors du réglage, nécessite que la borne E2 soit en permanence à la masse afin d'éviter de perturber le fonctionnement du circuit oscillant pendant le réglage.

Dans le montage de la figure 3 conforme à l'invention, l'élément selfique S est constitué d'un élément conducteur creux de bout en bout et dont la dimension intérieure est suffisante pour permettre d'une part l'insertion du noyau ajustable NA et d'autre part celle du tournevis TV; une extrémité E1 est connectée à la masse, l'autre extrémité est en contact avec le condensateur variable CV.

Du fait que les courants HF d'une fréquence d'au moins 300 MHz circulent à la surface de l'élément selfique, le tournevis TV ne perturbe pas le fonctionnement du circuit oscillant.

L'élément selfique S est avantageusement en forme de tube cylindrique mais ceci n'est pas une obligation; son diamètre extérieur et sa longueur sont adaptés à la bande de fréquences de fonctionnement du circuit oscillant pour former la valeur de self souhaitable.

Pour la bande UHF et pour un élément selfique en zamac, un tube convenable a un diamètre extérieur de 6 mm et une longueur de 50 mm; le diamètre intérieur est avantageusement adapté à la taille du tournevis pour lui servir de guidage.

Ainsi, selon l'invention, la contrainte pratique de connexion est inversée, puisque c'est la borne E1 qui doit être à la masse et non plus E2.

Le principe de montage ci-dessus exposé en détail pour un circuit oscillant réglable est clairement utilisable pour d'autres types de composants passifs tels que montré sur la figure 4.

Sur la figure 4 on retrouve l'élément selfique ES et un élément d'impédance variable EIV de nature quelconque, l'ensemble étant à connecter dans un circuit électrique entre les bornes E1 et E2.

L'embout de réglage ER du composant EIV est accessible par un tournevis TV à travers le creux CR de l'élément selfique.

L'élément EIV peut être principalement capacitif comme déjà décrit, principalement résistif, comme un potentiomètre, principalement selfique, ou quelconque.

Dans tous les cas, les deux éléments du composant passif peuvent être connectés par simple contact, par soudure ou autre. Ils peuvent aussi être de construction monobloc, au moins en ce qui concerne le boîtier.

## Revendications

1. Composant passif réglable, pour signaux d'au moins 300 MHz, composé d'au moins deux éléments connectés entre eux à savoir un élément selfique et un élément d'impédance de valeur réglable lequel élément comporte à une extrémité un embout accessible pour son réglage caractérisé en ce que le dit élément selfique est constitué au moyen d'un conducteur creux d'une extrémité à l'autre et dont une extrémité est connectée au dit élément d'impédance réglable, et en ce que le dit embout de réglage est situé en vis à vis du dit creux selon un agencement tel que d'une part l'embout est accessible à travers le dit creux pour son réglage, d'autre part l'introduction, même momentanée, d'un outil de réglage dans le dit creux ne perturbe pas le fonctionnement du composant passif réglable.

2. Composant selon la revendication 1 caractérisé en ce que le dit élément selfique creux est de forme tubulaire cylindrique ou légèrement conique.

3. Composant selon la revendication 2 caractérisé en ce que le dit tube a un diamètre intérieur de dimensions telles qu'il sert de guide pour l'introduction de l'outil de réglage.

4. Composant selon la revendication 1, 2 ou 3 caractérisé en ce que, au moins le dit élément selfique creux est constitué d'un matériau conducteur.

5. Composant selon la revendication 1, 2 ou 3 caractérisé en ce que, au moins le dit élément selfique creux est constitué d'un matériau plastique non conducteur revêtu au moins extérieurement d'une couche conductrice.

6. Composant selon l'une quelconque des revendications 1 à 5 caractérisé en ce que, la dite impédance variable est principalement capacitive pour constituer ainsi un circuit oscillant réglable.

7. Composant selon l'une quelconque des revendications 1 à 5 caractérisé en ce que la dite impédance variable est principalement résistive.

8. Composant selon l'une quelconque des revendications 1 à 5 caractérisé en ce que, la dite impédance variable est principalement selfique.

9. Composant selon l'une quelconque des revendications précédentes caractérisé en ce que, il est de construction monobloc au moins en ce qui concerne le boîtier.

## Patentansprüche

1. Einstellbares passives Bauelement für Signale von wenigstens 300 MHz, das aus wenigstens zwei miteinander verbundenen Teilelementen besteht, d.h. einem Drosselelement und einem Impedanzelement mit Einstellwert, das an einem Ende einen für seine Einstellung zugänglichen Aufsatz, dadurch gekennzeichnet, daß das Drosselelement durch einen sich von einem zum anderen Ende erstreckenden Hohlleiter besteht und von dem ein Ende mit dem einstellbaren Impedanzelement verbunden ist, und daß der Stellaufsatz sich gegenüber diesem Hohlraum in einer derartigen Anordnung befindet, daß einerseits der Aufsatz durch diesen Hohlraum hindurch für die Einstellung erreichbar ist, und zum anderen das Einführen, sogar momentan, eines Stellwerkzeugs in diesen Hohlraum die Wirkung des einstellbaren passiven Bauelements nicht beeinträchtigt wird.

2. Bauelement nach Anspruch 1, dadurch gekennzeichnet, daß das Drossel-Hohlelement eine rohrförmige Zylinderform oder eine etwas kegelige Form hat.

3. Bauelement nach Anspruch 2, dadurch gekennzeichnet, daß das Rohr einen Innendurchmesser mit derartigen Abmessungen hat, daß es zum Führen beim Einbringen des Stellwerkzeugs dient.

4. Bauelement nach Anspruch 1, 2 oder 3, dadurch gekennzeichnet, daß wenigstens das Drossel-Hohlelement aus einem Leitmaterial besteht.

5. Bauelement nach Anspruch 1, 2 oder 3, dadurch gekennzeichnet, daß wenigstens das Drossel-Hohlelement aus einem nichtleitenden Kunststoff besteht, der wenigstens auswendig mit einer Leitschicht bedeckt ist.

6. Bauelement nach einem oder mehreren der Ansprüche 1 bis 5, dadurch gekennzeichnet, daß die einstellbare Impedanz hauptsächlich kapazitiv ist, um auf diese Weise einen einstellbaren Schwingkreis zu bilden.

7. Bauelement nach einem oder mehreren der Ansprüche 1 bis 5, dadurch gekennzeichnet, daß die einstellbare Impedanz hauptsächlich ohmsch ist.

8. Bauelement nach einem oder mehreren der Ansprüche 1 bis 5, dadurch gekennzeichnet, daß die einstellbare Impedanz hauptsächlich selbstinduktiv ist.

9. Bauelement nach einem oder mehreren der vorangehenden Ansprüche, dadurch gekennzeichnet, daß es wenigstens hinsichtlich des Gehäuses aus einem Stück besteht.

## Claims

1. An adjustable passive component for signals of at least 300 MHz which is composed of at least two interconnected elements, i.e. an inductance element and an impedance element of adjustable value which at one end comprises an adjusting member which is accessible for its adjustment, characterized in that said inductance element is formed by a conductor which is hollow from one end end to the other and one end of which is connected to said adjustable impedance element, and in that said adjusting member is situated opposite said hollow so that on the one hand the adjusting member is accessible through said hollow for adjustment and that on the other hand the introduction of, even momentary, an adjusting tool into said hollow does not disturb the operation of the adjustable passive component.

2. A component as claimed in Claim 1, characterized in that said hollow inductance element has a cylindrical or slightly conical tubular shape.

3. A component as claimed in Claim 2, characterized in that the inner diameter of said tube is proportioned so that it serves as a guide for the introduction of the adjusting tool.

4. A component as claimed in Claim 1, 2 or 3, characterized in that at least said hollow inductance element is made of a conductive material.

5. A component as claimed in Claim 1, 2 or 3, characterized in that at least said hollow inductance element is made of a nonconductive plastics material provided with a conductive layer at least on its exterior surface.

6. A component as claimed in any one of the Claims 1 to 5, characterized in that said variable impedance is essentially capacitive in order to form an adjustable oscillatory circuit.

7. A component as claimed in any one of the Claims 1 to 5, characterized in that said variable impedance is essentially resistive.

8. A component as claimed in any one of the Claims 1 to 5, characterized in that said variable impedance is essentially inductive.

9. A component as claimed in any one of the preceding Claims, characterized in that it is constucted as a single block, at least as far as the casing is concerned.
